# EUROPÄISCHE PATENTSCHRIFT

(11) **EP 0 893 250 B1**
(45) Veröffentlichungstag und Bekanntmachung des Hinweises auf die Patenterteilung: **04.06.2003**
(21) Anmeldenummer: 98113527.0
(22) Anmeldetag: 20.07.1998
(51) Int. Cl.: B32B 35/00, B09B 5/00

(54) **Verfahren zum Trennen der Komponenten einer Verbundglasscheibe**
Method for separating the components of a laminated glazing
Procédé pour séparer les composants d'un vitrage feuilleté

(30) Priorität: 21.07.1997 DE 19731160
(43) Veröffentlichungstag der Anmeldung: 27.01.1999
(73) Patentinhaber: Deutsche Solar AG, 09599 Freiberg (DE)
(72) Erfinder: Wambach, Karsten Dr., 40885 Ratingen (DE); Stötzel, Eberhard Dr., 46348 Raesfeld (DE)
(74) Vertreter: Rau, Albrecht

(56) Entgegenhaltungen:
- EP-A- 0 648 829
- DE-C- 4 418 573
- US-A- 4 738 753
- PATENT ABSTRACTS OF JAPAN vol. 17, no. 205 (C-1051), 22. April 1993 & JP 04 349152 A (SEKISUI CHEM CO LTD), 3. Dezember 1992

## Beschreibung

Die Erfindung betrifft ein Verfahren zum Trennen der Komponenten einer Verbundglasscheibe, die in einer Gasatmosphäre thermisch behandelt wird.

Ein solches Verfahren ist aus dem Statusreport 1996, Photovoltaik. Berichtsnummer 76, "Untersuchungen zu den technischen Möglichkeiten der Verwertung und des Recyclings von Solarmodulen auf Basis von kristallinem und amorphem Silizium", des Bundesministeriums für Bildung, Wissenschaft, Forschung und Technologie, bekannt. Zur Trennung von photovoltaischen Solarmodulen mit in einer Ethylenvinylacetat-Folie eingebetteten Solarzellen wird darin vorgeschlagen, die Solarmodul-Verbundglasscheibe mittels Heißluft auf Temperaturen zwischen 150 und 250 Grad C zu erwärmen, wodurch eine deutlich verringerte Glashaftung des Kunststoffes erreicht wird. Das rasche Erwärmen auf Temperaturen oberhalb von 250 Grad C wird für bestimmte Materialien als problematisch angesehen.

Die thermische Zersetzung wird auf von T M Bruton et al in "Re-Cycling of High Value, High Energy Content Components of Silicon PV Modules", veröffentlicht in 12^{th} European Photovoltaic Solar Energy Conference, April 1994, als kritisch angesehen, insbesondere in bezug auf die Auswirkungen auf Solarzellen, da der verkohlende Kunststoff den Silizium-Wafer vollständig unbrauchbar mache.

Eine weitere Möglichkeit, die Komponenten von Verbundglasscheiben zu trennen, ist in der DE 44 18 573 C1 offenbart, gemäß der vorgesehen ist, die aufzubereitenden Verbundglasscheiben zunächst in einem Wirbelbettofen bei ca. 450 bis 500 Grad C zu erhitzen und dann abzuschrecken, wobei die Glasbestandteile zerbrechen und hiernach ausgesiebt werden. Ein Verfahren gemäβ dem Oberbegriff des Anspruchs 1 ist bekannt aus JP-A-04349152. Bei dem aus der JP-A-04 34 91 52 bekannten Verfahren zum Trennen der Komponenten einer Verbundglasscheibe wird letztere in einen Heißlufttrockenofen eingebracht, in dem ein Temperaturniveau von ca. 350 Grad C herrscht. In diesem Heißlufttrockenofen wird die Verbundglasscheibe aufgeheizt. Aufgrund der in dem Heißlufttrockenofen herrschenden Temperaturverhältnisse wird eine Kunststoffzwischenschicht der Verbundglasscheibe gleichmäßig geschmolzen und verbrannt. Die beiden zu der Verbundglasscheibe gehörenden Glasscheiben werden hierdurch voneinander getrennt. Eine Zerstörung dieser Glasscheiben findet bei dem aus der genannten Druckschrift bekannten Verfahren nicht statt.

Ausgehend von dem vorstehend geschilderten gattungsbildenden Verfahren liegt der Erfindung die Aufgabe zugrunde, ein Verfahren zum Trennen der Komponenten einer Verbundglasscheibe zur Verfügung zu stellen, bei dem in der Verbundglasscheibe enthaltene sensitive Komponenten, wie elektrische Einrichtungen oder Solarzellen, neben der zumindest einen anorganischen Glasscheibe zerstörungsfrei wiedergewonnen werden können.

Diese Aufgabe wird erfindungsgemäß durch ein Verfahren mit den im Patentanspruch 1 angegebenen Merkmalen gelöst.

Erfindungsgemäß ist vorgesehen, daß die Verbundglasscheibe, bei der mindestens eine anorganische Glasscheibe - gegebenenfalls über einen haftvermittelnden Kleber - mit einer Kunststoffschicht verbunden ist, mit einer maximal 50 Grad C/min betragenden Aufheizrate auf eine Endtemperatur von mindestens 300 Grad C aufgeheizt wird. Bevorzugt wird dabei mit einer Aufheizrate von maximal 30 Grad C/min, insbesondere von maximal 5 Grad C/min gearbeitet. Es versteht sich, daß der Aufheizvorgang im Normalfall von Raumtemperatur ausgeht. Im Anschluß an die Aufheizphase wird erfindungsgemäß die Verbundglasscheibe in einer Haltephase auf der Endtemperatur gehalten, bis die Kunststoffschicht im wesentlichen thermisch zersetzt und/oder verdampft ist.

Im wesentlichen thermisch zersetzt und/oder verdampft meint im Rahmen der Erfindung, daß die zu Beginn der Behandlung vorhandene Kunststoffschicht praktisch vollständig, das heißt typischerweise zu mindestens 95 %, von der Glasscheibe entfernt ist oder so zersetzt ist, daß die Zersetzungsprodukte auf einfache Weise von der Glasscheibe mechanisch entfernbar sind, z.B. durch Abbürsten, Abblasen oder Abwischen.

Die Erfindung basiert auf der Erkenntnis, daß die thermische Trennung der Komponenten einer Verbundglasscheibe in einer Gasatmosphäre mit gezielt ausgewählter Aufheizrate sowie einer Haltephase nach Erreichen der Endtemperatur, durch die im allgemeinen eine gleichmäßige Temperaturverteilung erreicht wird, eine geringere thermische Belastung der Verbundglasscheibe und der darin zusätzlich angeordneten elektrischen Einrichtung oder Solarzelle bewirkt.

Bei Versuchen mit Verbundglasscheiben mit in einer Kunststoffschicht eingebetteten Solarzellen aus polykristallinem Silizium hat sich überraschenderweise gezeigt, daß sich nicht nur die Glasscheiben unzerstört zurückgewinnen lassen, sondern daß auch die Solarzellen nur geringfügige Veränderungen durch die erfindungsgemäße Behandlung erfahren. Die freigelegten Solarzellen waren unmittelbar nach der Behandlung bzw. nach einer Reinigung und Ätzung zum Siliziumwafer und nach Neuprozessierung zur Solarzelle wieder zum Umwandeln von Strahlungsenergie in elektrische Energie nutzbar.

Für einige Verbundglasscheibenarten, insbesondere solche, die eine Kunststoffschicht mit einer hohen thermischen Stabilität aufweisen, z.B. aus Silikon, ist es zweckmäßig, auf eine Endtemperatur von mindestens 600 Grad C aufzuheizen.

Die Länge der Haltephase bei der Endtemperatur richtet sich danach, wie weit die Trennung der Komponenten der Verbundglasscheibe beim Erreichen der Endtemperatur bereits fortgeschritten ist. Ihre Länge kann im Extremfall wenige Sekunden betragen. Sie hat jedoch im Normalfall eine Dauer von mindestens 5 min.

Bevorzugt wird in der Aufheizphase zum überwiegenden Teil eine konstante Aufheizrate eingestellt. Es kann jedoch auch sinnvoll sein, in der Aufheizphase mindestens eine zusätzliche Haltephase mit im wesentlichen konstanter oder gar geringfügig absinkender Temperatur einzulegen.

Nach dem Abschluß der Zersetzung und/oder Verdampfung der Kunststoffschicht am Ende der Haltephase erfolgt ein Abkühlen der verbleibenden Komponenten der Verbundglasscheibe, typischerweise bis auf Raumtemperatur. Zur Reduzierung thermisch induzierter Spannungen wird bevorzugt mit einer den Betrag von 50 Grad C/min nicht überschreitenden Abkühlrate gearbeitet. Besonders bevorzugt ist, daß der Betrag der Abkühlrate 30 Grad C/min, insbesondere 5 Grad C/min, nicht überschreitet.

In der Regel wird das Abkühlen mit im wesentlichen konstanter Abkühlrate erfolgen. Auch für die Abkühlphase kann es allerdings vorteilhaft sein, mindestens eine Haltephase mit im wesentlichen konstanter Temperatur einzulegen.

Die thermische Behandlung der Verbundglasscheibe erfolgt zumindest in der Aufheizphase und/oder in der Haltephase vorteilhafterweise in einer ein Oxidationsmittel für die Kunststoffschicht enthaltenden Gasatmosphäre. Die genaue Zusammensetzung der einzustellenden Gasatmosphäre hängt von der Art und dem Aufbau der Verbundglasscheibe, die behandelt werden soll, ab. Ist beispielsweise die Verbundglasscheibe im technischen Sinne unproblematisch, kann es völlig ausreichend sein, die Verbundglasscheibe in Luft aufzuheizen und innerhalb der Haltephase thermisch zu behandeln. Um die Oxidation der Kunststoffanteile der Verbundglasscheibe zu begünstigen, kann jedoch in der Aufheizphase und/oder der Haltephase auch in einer mit Sauerstoff angereicherten Gasatmosphäre gearbeitet werden. Hierbei ist allerdings Vorsicht geboten, da der Einsatz von Sauerstoff zu einer verstärkten exothermen Reaktion führen kann, die schwer kontrollierbar ist und bis zum Schmelzen der Glasscheiben führen kann. Daher wird vorteilhafterweise, wenn der in der Gasatmosphäre bzw. in der Luft enthaltene Sauerstoff in der Aufheizphase verbrennt, dieser nur in geringen und wohldosierten Mengen nachgeliefert. Dieses Vorgehen kann zwar zunächst zu einer stärkeren Karbonisierung der Kunststoffe führen, erleichtert aber die Temperatursteuerung. Wenn der Kunststoff weitgehend zersetzt ist, kann der Sauerstoffgehalt der Gasatmosphäre wieder erhöht werden, ohne daß es zu störenden exothermen Reaktionen kommt.

Neben Sauerstoff kann der Gasatmosphäre als Oxidationsmittel auch mindestens eines der Gase CO₂, H₂O, SO₂, SO, O₃, NO₂ oder Cl₂ zugesetzt werden. Dabei vereinfacht es das Behandlungsverfahren, wenn in der Aufheizphase und der Haltephase sowie gegebenenfalls in der Abkühlphase der Gasatmosphäre eine im wesentlichen gleich zusammengesetzte Gasmischung zugeführt wird.

Um im Falle der thermischen Behandlung von Solarmodulen oder dergleichen eine besonders schonende Oxidation des Kunststoffmaterials ohne nennenswerte Korrosion der Metalle der Leiterbahnen und der Solarzellen zu erhalten, sollten in diesem Falle möglichst Reaktionsbedingungen eingestellt werden, die zu einem selektiven Angriff auf das Kunststoffmaterial führen. Dazu wird beispielsweise Sauerstoff unter definierten Bedingungen in geringen Konzentrationen der Gasatmosphäre zugesetzt. Der Sauerstoffanteil an der Gasatmosphäre wird typischerweise zwischen 2 und 25 Vol.% eingestellt. Eine Reduzierung des Sauerstoffanteils, beispielsweise am Anfang der Aufheizphase, kann beispielsweise indirekt durch das Beimischen von Argon, Stickstoff oder anderen Inertgasen erfolgen, aber auch durch das Beimischen reduzierender Gase, wie Ammoniak, Erdgas bzw. seiner Komponenten oder Wasserstoff, die dann in der Gasatmosphäre vorverbrannt werden. Die dabei entstehende Wärme kann direkt für die Ofenbeheizung genutzt werden. Bevorzugt enthält die der Gasatmosphäre während der thermischen Behandlung der Verbundglasscheibe zugeführte Gasmischung mindestens ein Oxidationsmittel mit einem Anteil von 1 - 30 Vol.% und mindestens ein Inertgas mit einem Anteil von 70-99 Vol.%.

Die Zersetzungsgeschwindigkeit und der Verlauf der Zersetzungsreaktionen kann bei Bedarf auch dadurch gesteuert werden, daß die Verbundglasscheibe zumindest zeitweise bei Unterdruck thermisch behandelt wird.

Das Verfahren nach der Erfindung kann gezielt beeinflußt, insbesondere abgekürzt werden, wenn zumindest das Aufheizen der Verbundglasscheibe in Anwesenheit eines die Zersetzung der Kunststoffschicht beeinflussenden Reaktionshilfsmittels, z.B. eines Katalysators oder einer die Zersetzung der Kunststoffschicht fördernden Chemikalie, durchgeführt wird. Zweckmäßigerweise wird dazu vor dem Aufheizen der Verbundglasscheibe das Reaktionshilfsmittel auf die freiliegenden Randbereiche der Kunststoffschicht aufgetragen. Alternativ kann das Reaktionshilfsmittel der Gasathmosphäre als flüchtige Verbindung zugesetzt werden. Das Reaktionshilfsmittel kann gegebenenfalls auch als Inhibitor wirken, das die Reaktionsgeschwindigkeit und damit auch die Wärmetönung der Reaktion steuert. Als Reaktionshilfsmittel ist insbesondere eine sauer oder alkalisch wirkende Verbindung wie SO₂, AlCl₃, NH₃ oder CaO geeignet. Vorzugsweise beträgt der Anteil eines gasförmigen Reaktionshilfsmittels in der der Gasatmosphäre zugeführten Gasmischung 0,01 - 5 Vol.%.

Die Trennung der Komponenten der Verbundglasscheibe kann dadurch unterstützt werden, daß an der Verbundglasscheibe vor Beginn der Aufheizphase Einrichtungen zur mechanischen Separierung der einzelnen Komponenten angebracht, insbesondere am Rand in die Kunststoffschicht eingedrückt werden. Die hierdurch erzeugbare elastische Vorspannung erleichtert das Eindringen der Gasatmosphäre in die Verbundglasscheibe und kann zu einer beschleunigten Zersetzung der Kunststoffschicht führen.

Bei der Anwendung des erfindungsgemäßen Verfahrens ist durch entsprechende Regelung der Zusammensetzung der Gasatmosphäre sowie ihrer Temperatur darauf zu achten, daß keine zu starke exotherme Reaktion erfolgt, die zu Flammenbildung im Randbereich der Verbundglasscheibe führt. Dies würde zu starken Inhomogenitäten in der Temperaturverteilung im Ofen und innerhalb der Verbundglasscheiben führen und die Erreichung des Ziels einer Wiederverwertbarkeit von deren Komponenten gefährden.

Das Verfahren wird mit besonderem Vorteil zur thermischen Behandlung von Verbundglasscheiben eingesetzt, bei denen mindestens eine Glasscheibe aus Kalknatronsilikatglas oder Borosilikatglas besteht. Eine andere bevorzugte Anwendung besteht in der thermischen Behandlung von Verbundglasscheiben mit einer Kunststoffschicht, die aus aliphatischen oder aromatischen Polyurethanen, Polyvinylbutyral, Ethylenvinylacetat, Acrylsäurederivaten, wie n-Butylacrylat, Epoxiden, Silikonen oder Gemischen daraus bestehen.

Besondere Vorteile ergeben sich bei der erfindungsgemäßen thermischen Behandlung von Verbundglasscheiben mit auf der Kunststoffschicht aufliegenden und/oder in dieser eingebetteten Solarzellen, wenn die Solarzellen aus Silizium, Kupfer-Auch Verbundglasscheiben, insbesondere Verbundsicherheitsglasscheiben, bei denen auf die Kunststoffschicht mindestens eine weitere Glasscheibe auflaminiert ist, wobei also die Kunststoffschicht die Verbundschicht zweier Glasscheiben bildet, können mit dem erfindungsgemäßen Verfahren behandelt werden. Hier ist es dann besonders zweckmäβig, vor Beginn der thermischen Behandlung Einrichtungen, wie z.B. Keile oder Spreizelemente, in die Kunststoffschicht einzubringen, beispielsweise randseitig einzudrücken, die die Glasscheiben auf Abstand halten. Das Verfahren ist aber auch geeignet zur Behandlung von Abstandhalter aufweisenden Isolierglasscheiben.

Eine bevorzugte Vorrichtung zum Durchführen des erfindungsgemäßen Verfahrens umfaßt einen beheizbaren Gestellofen, der mindestens eine Gaszuführung für das Zusetzen von Gasen zur Gasatmosphäre und mindestens eine Gasabsaugeinrichtung mit einer Einrichtung zum Nachverbrennen der Abgase aufweist. Zur Homogenisierung der Gasatmosphäre können mehrere Gaszuführungen zum Zuführen von Gasen an voneinander beabstandeten Stellen des Gestellofens vorgesehen sein. Energetisch besonders günstig kann gearbeitet werden, wenn eine Rückführeinrichtung für die bei der Nachverbrennung entstehende Abwärme in den Gestellofen vorgesehen ist. Eine Vorrichtung, mit der das Verfahren gemäß der Erfindung kontinuierlich gefahren werden kann, umfaßt ein endlos laufendes, warmfestes Transportband für die zu behandelnden Verbundglasscheiben, das durch eine Anzahl von Ofensegmenten geführt ist, wobei in den Ofensegmenten unterschiedliche Gasatmosphären und/oder Temperaturen einstellbar sind.

Im folgenden soll die Erfindung anhand der beigefügten Zeichnung sowie anhand von Beispielen erläutert werden.

Es zeigt
- Figur 1: den Temperaturverlauf an einer gemäß der Erfindung thermisch behandelten Verbundglasscheibe für die Aufheiz-, Halte- und Abkühlphase,
- Figur 2: den Reaktionsumsatz (Zersetzung/Verdampfung) des Kunststoffes der Kunststoffschicht einer Verbundglasscheibe unter bestimmten Reaktionsbedingungen
- Figur 3: unterschiedliche Verläufe des Partialdruckes eines für das Verfahren eingesetzten Oxidationsmittels in der Gasatmosphäre.

### Beispiel 1

Eine als photovoltaisches Solarmodul ausgebildete Verbundglasscheibe mit den Abmessungen 40 x 40 cm² bestand aus einer 4 mm dicken Abdeckscheibe aus eisenarmem Kalknatronsilikatglas, einer ebenfalls 4 mm dicken Trägerscheibe aus Kalknatronsilikatglas, sowie zwischen den Glasscheiben einer als Verbundschicht dienenden, 2 mm dicken Kunststoffschicht. Die Kunststoffschicht war durch Eingießen und anschließendes Aushärten einer Monomermischung auf Acrylatbasis mit einem Acrylatanteil von mehr als 80 Gew.% hergestellt worden, wobei in die Kunststoffschicht vier Solarzellen aus polykristallinem Silizium eingebettet worden waren. Die fertige Verbundglasscheibe wurde waagerecht in ein Stahlgestell eingesetzt und in einen Umluftofen eingebracht. In den freiliegenden Rand der Kunststoffschicht wurden voneinander beabstandet mehrere Metallkeile als Abstandhalter eingetrieben. In einem anderen Versuch wurden Haken eingesetzt, die mit kontrollierter Zugkraft belastet wurden und somit die Glasscheiben während der thermischen Behandlung voneinander getrennt hielten.

Die zunächst auf Raumtemperatur befindliche Verbundglasscheibe wurde in dem Ofen in Luft mit einer überwiegend konstanten Aufheizrate von 5°C/min auf eine Endtemperatur von 550°C aufgeheizt und bei dieser Temperatur etwa 30 min gehalten. Das Abkühlen auf eine Temperatur nahe Raumtemperatur erfolgte mit einer überwiegend konstanten Abkühlrate mit einem Betrag von 3°C/min. Der Temperatur/Zeit-Verlauf an der Glasscheibe ist aus Figur ersichtlich. Man erhielt unversehrte, vollständig von der Kunststoffschicht befreite Glasscheiben, unzerstörte Solarzellen und verzunderte Kupferverbinder als Verfahrensprodukte nebeneinander. Die Solarzellen wurden einem in der Halbleitertechnologie üblichen Waferreinigungsprozeß, der aus einer Folge von Ätzschritten mit sauren und alkalischen Medien besteht, unterzogen. Man erhielt Silizium-Wafer, die ohne nennenswerten Qualitätsverlust wieder zu Solarzellen verarbeitet werden konnten.

### Beispiel 2

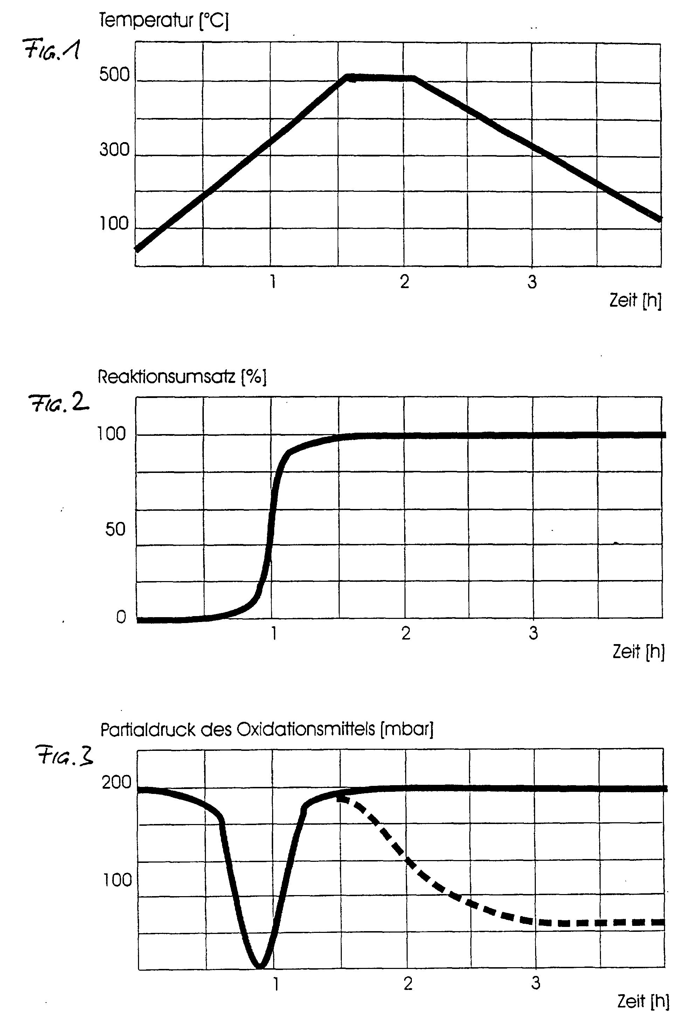

Zwei photovoltaische Solarmodule des gleichen Aufbaus wie in Beispiel 1, bei der jedoch die Kunststoffschicht aus einer 2 mm dicken, aus einer Monomermischung mit ca. 78 Gew.-% n-Butylacrylat gebildeten Schicht bestand, wurden in einem gasdichten Kammerofen gemäß dem Temperatur/Zeit-Verlauf nach Fig. 1 behandelt.

In der Aufheizphase begann oberhalb von etwa 300°C eine exotherme Reaktion der Kunststoffschicht mit dem als Oxidationsmittel wirkenden Sauerstoff der Luft als Oxidationsmittel, wie dies aus der Darstellung des zeitlichen Verlaufs des Reaktionsumsatzes (prozentualer Anteil des bereits zersetzten/verdampften Kunststoffs) in Fig. 2 ersichtlich ist. Zum Schutz vor einem unerwünschten oxidativen Angriff auf die Solarzellen und die metallischen Verbinder wurde durch die Zugabe von Stickstoff als Inertgas der Sauerstoffanteil in der Gasatmosphäre auf unter 5 Vol.% vermindert und damit die Reaktionsgeschwindigkeit reduziert. Kurz vor Erreichen der angestrebten Endtemperatur war bereits ein hoher Volumenanteil (etwa 95 Vol.%) der Kunststoffschicht zersetzt (verbrannt) bzw. verdampft. Zur Vervollständigung der Entfernung der Kunststoffschicht wurde der Sauerstoffanteil in der Gasatmosphäre bis zum Erreichen der Endtemperatur durch Zufuhr von Luft wieder erhöht. Der Verlauf des Sauerstoffpartialdruckes in der Gasatmosphäre bei diesem Beipspiel ist in Fig. 3 als durchgezogene Linie dargestellt. Die verbliebenen Komponenten der Verbundglasscheiben wurden im Anschluß an die etwa eine halbe Stunde dauernde Haltephase durch Zugabe von kalter Luft langsam auf Raumtemperatur abgekühlt.

Sind die metallischen Komponenten und Halbleiterwerkstoffe in der zu behandelnden Verbundglasscheibe sehr oxidationsempfindlich, so kann in der Haltephase und/oder der Abkühlphase auch mit einer Gasatmosphäre mit reduziertem Gehalt an Oxidationsmittel gearbeitet werden. Hierzu kann der Gasatmosphäre beispielsweise ein Reduktionsmittel wie Wasserstoff zugesetzt werden, so daß letztlich in einer im wesentlichen Stickstoff enthaltenden Gasatmosphäre auf Raumtemperatur abgekühlt wird. Die gestrichelte Kurve in Figur 3 zeigt den Verlauf des Sauerstoffpartialdruckes in der Gasatmosphäre für die Haltephase und die Abkühlphase bei dem geschilderten Verfahren.

### Beispiel 3

Eine als photovoltaisches Solarmodul ausgebildete Verbundglasscheibe mit den Abmessungen 20 x 30 cm² bestand aus einer 3 mm dicken Abdeckscheibe aus eisenarmem Kalknatronsilikatglas, einer beidseitig mit Polyvinylfluorid beschichteten Polyesterfolie mit einer Gesamtdicke von 0,2 mm als Trägerschicht, sowie einer als Verbundschicht zwischen Glasscheibe und Polyesterfolie dienenden, 2 mm dikken Ethylenvinylacetat-Copolymer-Folie, in der vier Solarzellen aus monokristallinem Silizium eingebettet waren. Die.Verbundglasscheibe wurde mit der Trägerschicht nach oben waagerecht in einen Kammerofen eingebracht. Sie wurde mit einer im wesentlichen konstanten Aufheizrate von 10°C/min in Luft auf eine Endtemperatur von etwa 500°C aufgeheizt und bei dieser Temperatur ca. 40 min gehalten. Es schloß sich eine Abkühlung mit einer Abkühlrate mit einem Betrag von 5°C/min zunächst auf 120°C an, der eine zusätzliche Haltephase von ca. 5 min auf dieser Temperatur folgte. Die anschließende Abkühlung auf Raumtemperatur erfolgte mit der gleichen Abkühlrate wie zuvor.

Die Kunststoffanteile der Verbundglasscheibe waren nach Beendigung der thermischen Behandlung vollständig verbrannt. Auf der unversehrten Glasscheibe lagen die intakten Solarzellen und die Verbinder. Die Solarzellen konnten wie in Beispiel 1 erfolgreich zur Wiederverwertung weiterbehandelt werden.

### Beispiel 4

Eine als photovoltaisches Solarmodul ausgebildete Verbundglasscheibe mit den Abmessungen 40 x 40 cm² bestand aus einer 3 mm dicken Abdeckscheibe aus Kalknatronsilikatglas, die auf einer Seite mit Dünnschicht-Solarzellen aus Silizium beschichtet war. Auf die Solarzellenschicht war eine 4 mm dicke, aus einer Monomermischung mit ca. 78 Gew.-% n-Butylacrylatanteil gebildete Kunststoffschicht als Verbundschicht zu einer 4 mm dicken Trägerscheibe aus Kalknatronsilikatglas aufgetragen. Die Verbundglasscheibe war mit einer Randversiegelung aus Silikon versehen. Sie wurde vor Beginn der Behandlung mit einem vom Rand her in die Kunststoffschicht eingedrückten, unter Vorspannung gehaltenen Abstandhalter versehen. Mit fortschreitendem Verbrennen der Kunststoffschicht drang der Abstandhalter weiter in die Kunststoffschicht ein und sorgte so für eine zunehmenden Beabstandung zwischen der Abdeckscheibe und der Trägerscheibe, was das vollständige Beseitigen des Kunststoffes begünstigte. Ansonsten entsprachen die Versuchsbedingungen denen des Beispiels 1.

Nach dem Abschluß des Verfahrens lagen die unversehrten Glasscheiben getrennt voneinander vor. Die Dünnschichtsolarzeilen waren vollständig oxidiert. Auf den Glasscheiben blieb eine lockere, dünne Oxidschicht zurück, die jedoch die Einschmelzbarkeit des Glases und seine Wiederverwendung nicht beeinträchtigte.

Bei der industriellen Anwendung des erfindungsgemäßen Verfahrens kann im Batch-Betrieb und im kontinuierlichen Betrieb gearbeitet werden. Für den Batch-Betrieb ist besonders ein beheizbarer Gestellofen geeignet, der mindestens eine Gaszuführung für das Zusetzen von Gasen zur Gasatmosphäre und mindestens eine Gasabsaugeinrichtung aufweist, wobei das Abgas gegebenenfalls katalytisch nachverbrannt wird. Es werden bevorzugt warmfeste Stahlgestelle mit Stahlmatten-Auflagern eingesetzt, die unterschiedlichste Arten von zu behandelnden Verbundglasscheiben aufnehmen können. Es sollten möglichst mehrere Gaszuführungen zum Zuführen von Gasen an voneinander beabstandeten Stellen des Gestellofens vorgesehen sein, damit eine möglichst homogene Gasatmosphäre eingestellt werden kann. Zum kontinuierlichen Betrieb besonders geeignet ist ein Ofen mit einem endlos laufenden, warmfesten Transportband für die Verbundglasscheiben, das durch eine Anzahl von Ofensegmenten geführt ist, wobei in den Ofensegmenten unterschiedliche Gasatmosphären und/oder Temperaturen einstellbar sind.

## Patentansprüche

1. Verfahren zum Trennen der Komponenten einer Verbundglasscheibe, welche zumindest aus einer anorganischen Glasscheibe und einer mit dieser verbundenen Kunststoffschicht besteht, bei welchem Verfahren die Verbundglasscheibe in einer Gasatmosphäre thermisch behandelt wird, wobei die Verbundglasscheibe auf eine Endtemperatur von mindestens 300 Grad C aufgeheizt und in einer Haltephase auf dieser Endtemperatur gehalten wird, bis die Kunststoffschicht im wesentlichen thermisch zersetzt und/oder verdampft ist, **dadurch gekennzeichnet, daß** die Verbundglasscheibe weiter aus einer elektrischen Einrichtung und/oder aus einem Solarenergie-Umwandlungselement oder einer auf und/oder in der Kunststoffschicht angeordneten Solarzelle besteht, und daß die Verbundglasscheibe in einer Aufheizphase mit einer maximal 50 Grad C/min betragenden Aufheizrate aufgeheizt wird.

2. Verfahren nach Anspruch 1, bei dem die Verbundglasscheibe auf eine Endtemperatur von mindestens 600 Grad C aufgeheizt wird.

3. Verfahren nach einem der Ansprüche 1 oder 2, bei dem die Aufheizrate maximal 30 Grad C/min, vorzugsweise maximal 5 Grad C/min, beträgt.

4. Verfahren nach einem der Ansprüche 1 bis 3, bei dem die Haltephase eine Dauer von mindestens 5 min hat.

5. Verfahren nach einem der Ansprüche 1 bis 4, bei dem in der Aufheizphase zum überwiegenden Teil eine konstante Aufheizrate eingestellt wird.

6. Verfahren nach einem der Ansprüche 1 bis 4, bei dem in der Aufheizphase mindestens eine zusätzliche Haltephase mit im wesentlichen konstanter Temperatur vorgesehen. wird.

7. Verfahren nach einem der Ansprüche 1 bis 6, bei dem im Anschluß an die Haltephase das Abkühlen der verbleibenden Komponenten der Verbundglasscheibe mit einer Abkühlrate erfolgt, deren Betrag 50 Grad C/min nicht überschreitet.

8. Verfahren nach Anspruch 7, **dadurch gekennzeichnet, daß** der Betrag der Abkühlrate 30 Grad C/min, vorzugsweise 5 Grad C/min, nicht überschreitet.

9. Verfahren nach einem der Ansprüche 1 bis 8, bei dem die thermische Behandlung der Verbundglasscheibe zumindest in der Aufheizphase und in der Haltephase in einer ein Oxidationsmittel für die Kunststoffschicht enthaltenden Gasatmosphäre erfolgt.

10. Verfahren nach Anspruch 9, bei dem als Gasatmosphäre überwiegend Luft eingesetzt wird.

11. Verfahren nach Anspruch 9 oder 10, bei dem der Gasatmosphäre mindestens eines der Gase O₂, CO₂, H₂O, SO₂, SO₃, O₃, NO₂ oder Cl₂ zugesetzt wird.

12. Verfahren nach einem der Ansprüche 9 bis 11, bei dem der Gasatmosphäre ein Inertgas, wie N₂ oder Ar, zugesetzt wird.

13. Verfahren nach einem der Ansprüche 9 bis 12, bei dem in der Aufheizphase und/oder in der Haltephase der Anteil an Oxidationsmittel in der Gasatmosphäre zur Begrenzung exothermer Reaktionen zeitweise reduziert wird.

14. Verfahren nach einem der Ansprüche 9 bis 13, bei dem der Gasatmosphäre während der thermischen Behandlung der Verbundglasscheibe eine Gasmischung zugeführt wird, die mindestens ein Oxidationsmittel mit einem Anteil von 1 - 30 Vol.% und mindestens ein Inertgas mit einem Anteil von 70 - 99 Vol.% enthält.

15. Verfahren nach einem der Ansprüche 1 bis 14, bei dem die thermische Behandlung der Verbundglasscheibe zumindest zeitweise bei Unterdruck erfolgt.

16. Verfahren nach einem der Ansprüche 1 bis 15, bei dem zumindest in der Aufheizphase ein die Zersetzung der Kunststoffschicht unterstützendes Reaktionshilfsmittel eingesetzt wird.

17. Verfahren nach Anspruch 16, bei dem als Reaktionshilfsmittel eine sauer oder alkalisch wirkende Verbindung, insbesondere SO, AICI₃, NH₃ oder CaO, eingesetzt wird.

18. Verfahren nach Anspruch 16 oder 17, bei dem das Reaktionshilfsmittel vor der Aufheizphase auf freiliegende Bereiche der Kunststoffschicht aufgetragen wird.

19. Verfahren nach Anspruch 16 oder 17, bei dem das Reaktionshilfsmittel der Gasatmosphäre als flüchtige Verbindung in einer Gasmischung zugesetzt wird.

20. Verfahren nach Anspruch 19, bei dem der Anteil des Reaktionshilfsmittels in der der Gasatmosphäre zugeführten Gasmischung 0,01 - 5 Vol.% beträgt.

21. Verfahren nach einem der Ansprüche 1 bis 20, bei dem an der Verbundglasscheibe vor Beginn der Aufheizphase Einrichtungen zur mechanischen Separierung der einzelnen Komponenten der Verbundglasscheibe angebracht werden, insbesondere am Rand in die Kunststoffschicht eingedrückt werden.

22. Verfahren nach einem der Ansprüche 1 bis 21 zur thermischen Behandlung von Verbundglasscheiben, die mindestens eine Glasscheibe aus Kalknatronsilikatglas oder Borosilikatglas aufweisen.

23. Verfahren nach einem der Ansprüche 1 bis 21 zur thermischen Behandlung von Verbundglasscheiben mit mindestens einer Kunststoffschicht, welche im wesentlichen aus aliphatischen oder aromatischen Polyurethanen, Polyvinylbutyral, Ethylenvinylacetat, Acrylsäurederivaten wie n-Butylacrylat, Epoxiden, Silikonen oder Gemischen daraus besteht.

24. Verfahren nach einem der Ansprüche 1 bis 21 zur thermischen Behandlung von Verbundglasscheiben, dem auf und/oder in der Kunststoffschicht angeordnete Solarzellen aus Silizium, Kupfer-Indium-Diselenid, Galliumsarsenid oder Cadmiumtellurid bestehen.

25. Verfahren nach einem der Ansprüche 1 bis 21 zur thermischen Behandlung von Verbundglasscheiben, bei denen mit der Kunststoffschicht als weitere Komponente mindestens eine weitere Glasscheibe verbunden ist, insbesondere zur thermischen Behandlung von Abstandhalter aufweisenden Isolierglasscheiben oder von Verbundsicherheitsglasscheiben.

## Claims

1. Method of separating the components of laminated glazing that is comprised of at least an inorganic pane and a plastic layer joined thereto, wherein the laminated glazing is thermally treated in a gas atmosphere, with the laminated glazing being heated to a final temperature of at least 300°C and kept at this final temperature in a maintenance phase until the plastic layer is substantially thermally decomposed and/or evaporated, **characterized in that** the laminated glazing further comprises electrical equipment and/or a solar energy conversion element or a solar cell which is disposed on and/or in the plastic layer; and **in that** the laminated glazing, in a heating phase, is heated by a heating rate of maximally 50°C/min.

2. Method according to claim 1, wherein the laminated glazing is heated to a final temperature of at least 60°C.

3. Method according to one of claims 1 or 2, wherein the heating rate amounts to a maximum of 30°C/min, preferably to a maximum of 5°C/min.

4. Method according to one of claims 1 to 3, wherein the maintenance phase has a duration of at least 5 min.

5. Method according to one of claims 1 to 4, wherein a constant heating rate is predominantly set in the heating phase.

6. Method according to one of claims 1 to 4, wherein at least one additional maintenance phase of substantially temperature is provided in the heating phase.

7. Method according to one of claims 1 to 6, wherein after the maintenance phase, cooling of the remaining components of the laminated glazing takes place at a cooling rate the amount of which does not exceed 50°C/min.

8. Method according to claim 7, **characterized in that** the amount of the cooling rate does not exceed 30°C/min, preferably 5°C/min.

9. Method according to one of claims 1 to 8, wherein thermal treatment of the laminated glazing takes place, at least in the heating phase and in the maintenance phase, in a gas atmosphere that contains an oxidizing agent for the plastic layer.

10. Method according to claim 9, wherein air is predominantly used as gas atmosphere.

11. Method according to claim 9 or 10, wherein at least one of the gases 0₂, CO₂, H₂O, SO₂, SO₃, O₃, NO₂ or Cl₂ is added to the gas atmosphere.

12. Method according to one of claims 9 to 11, wherein an inert gas such as N₂ or Ar is added to the gas atmosphere.

13. Method according to one of claims 9 to 12, wherein the proportion of oxidizing agent in the gas atmosphere is reduced from time to time in the heating phase and/or maintenance phase for limitation of exothermal reactions.

14. Method according to one of claims 9 to 13, wherein a gas mixture is supplied to the gas atmosphere during thermal treatment of the laminated glazing, containing at least an oxidizing agent at a proportion of 1 - 30 percent by volume and at least an inert gas at a proportion of 70 - 99 percent by volume.

15. Method according to one of claims 1 to 14, wherein thermal treatment of the laminated glazing takes place at underpressure at least from time to time.

16. Method according to one of claims 1 to 15, wherein a reaction aid is employed at least during the heating phase, aiding in the decomposition of the plastic layer.

17. Method according to claim 16, wherein a compound of acidic or alkaline action, in particular SO, AICI₃, NH₃ or CaO, is used as a reaction aid.

18. Method according to claim 16 or 17, wherein the reaction aid is applied to free areas of the plastic layers before the heating phase.

19. Method according to claim 16 or 17, wherein the reaction aid of the gas atmosphere is added as a volatile compound in a gas mixture.

20. Method according to claim 19, wherein the proportion of the reaction aid in the gas mixture that is added to the gas atmosphere amounts to 0.01 - 5 percent by volume.

21. Method according to one of claims 1 to 20, wherein, prior to the start of the heating phase, means for mechanically separating the individual components of the laminated glazing are attached to the laminated glazing, in particular pressed marginally into the plastic layer.

22. Method according to one of claims 1 to 21 for thermal treatment of laminated glazing having at least a pane of soda-lime silicate glass or borosilicate glass.

23. Method according to one of claims 1 to 21 for thermal treatment of laminated glazing having at least one plastic layer which substantially consists of aliphatic or aromatic polyurethane, polyvinyl butyral, ethylene vinyl acetate, acrylic acid derivatives such as butyl acrylate, epoxides, silicones or mixtures thereof.

24. Method according to one of claims 1 to 21 for thermal treatment of laminated glazing, wherein solar cells that are arranged on and/or in the plastic layer consist of silicon, copper indium diselenide, gallium arsenide or cadmium telluride.

25. Method according to one of claims 1 to 21 for thermal treatment of laminated glazing in which at least a further pane is joined as another component to the plastic layer, in particular for thermal treatment of insulating glass panes or of laminated safety glass panes.

## Revendications

1. Procédé pour séparer les composants d'une plaque de verre feuilleté qui est constituée au moins à partir d'une plaque de verre inorganique et d'une couche de matière plastique reliée à celle-ci, procédé dans lequel la plaque de verre est soumise à un traitement thermique en atmosphère gazeuse, la plaque de verre feuilleté étant chauffée à une température finale d'au moins 300°C et maintenue à cette température finale dans une phase de maintien jusqu'à ce que la couche de matière plastique soit sensiblement décomposée thermiquement et/ou évaporée, **caractérisé en ce que** la plaque de verre feuilleté est en outre constituée à partir d'un dispositif électrique et/ou d'un élément de conversion d'énergie solaire ou d'une cellule solaire agencée sur et/ou dans la couche de matière plastique, et **en ce que** la plaque de verre feuilleté est chauffée dans une phase d'échauffement avec un taux d'échauffement se montant à 50°C/mn au maximum.

2. Procédé selon la revendication 1, dans lequel la plaque de verre feuilleté est chauffée à une température finale d'au moins 600°C.

3. Procédé selon l'une ou l'autre des revendications 1 et 2, dans lequel le taux d'échauffement est de 30°C/mn au maximum, de préférence 5°C/mn.

4. Procédé selon l'une des revendications 1 à 3, dans lequel la phase de maintien a une durée d'au moins 5 mn.

5. Procédé selon l'une des revendications 1 à 4, dans lequel un taux d'échauttement constant est réglé pour la majeure partie de la phase d'échauffement

6. Procédé selon l'une des revendications 1 à 4, dans lequel dans la phase d'échauffement, il est prévu au moins une phase de maintien additionnelle avec une température sensiblement constante.

7. Procédé selon l'une des revendications 1 à 6, dans lequel à la suite de la phase de maintien, le refroidissement des composants subsistants de la plaque de verre feuilleté a lieu avec un taux de refroidissement dont la valeur ne dépasse par 50°C/mn.

8. Procédé selon la revendication 7, **caractérisé en ce que** la valeur du taux de refroidissement ne dépasse pas 30°C/mn, de préférence pas 5°C/mn.

9. Procédé selon l'une des revendications 1 à 8, dans lequel le traitement thermique de la plaque de verre feuilleté a lieu, au moins dans la phase d'échauffement et dans la phase de maintien, dans une atmosphère gazeuse contenant un oxydant pour la couche de matière plastique.

10. Procédé selon la revendication 9, dans lequel on utilise principalement de l'air en tant qu'atmosphère gazeuse.

11. Procédé selon l'une ou l'autre des revendications 9 et 10, dans lequel on ajoute à l'atmosphère gazeuse au moins un des gaz O₂, CO₂, H₂O, SO₂, SO₃, O₃, NO₂ ou Cl₂.

12. Procédé selon l'une des revendications 9 à 11, dans lequel on ajoute à l'atmosphère gazeuse un gaz inerte tel que N₂ ou Ar.

13. Procédé selon l'une des revendications 9 à 12, dans lequel dans la phase d'échauffement et/ou dans la phase de maintien, la part d'oxydant dans l'atmosphère gazeuse est réduite temporairement pour limiter des réactions exothermes.

14. Procédé selon l'une des revendications 9 à 13, dans lequel on ajoute à l'atmosphère gazeuse pendant le traitement thermique de la plaque de verre feuilleté un mélange gazeux qui contient au moins une part de 1 à 30 % en volume d'un oxydant et au moins une part de 70 à 99 % en volume d'un gaz inerte.

15. Procédé selon l'une des revendications 1 à 14, dans lequel le traitement thermique de la plaque de verre feuilleté a lieu au moins temporairement sous dépression.

16. Procédé selon l'une des revendications 1 à 15, dans lequel au moins dans la phase d'échauffement, on utilise un agent auxiliaire de réaction qui favorise la décomposition de la couche de matière plastique.

17. Procédé selon la revendication 16, dans lequel on utilise en tant qu'agent auxiliaire de réaction un composé à action acide ou alcaline, en particulier SO, AlCl ₃, NH₃ ou CaO.

18. Procédé selon l'une ou l'autre des revendications 16 et 17, dans lequel l'agent auxiliaire de réaction est appliqué avant la phase d'échauffement sur des régions dégagées de la couche de matière plastique.

19. Procédé selon l'une ou l'autre des revendications 16 et 17, dans lequel l'agent auxiliaire de réaction est ajouté à l'atmosphère gazeuse sous forme de composé volatile dans un mélange gazeux.

20. Procédé selon la revendication 19, dans lequel la part de l'agent auxiliaire de réaction dans le mélange de gaz amené à l'atmosphère gazeuse est de 0,01 à 5 % en volume.

21. Procédé selon l'une des revendications 1 à 20, dans lequel avant le début de la phase d'échauffement, des dispositifs de séparation mécanique des composants individuels de la plaque de verre feuilleté sont montés sur la plaque de verre feuilleté, en particulier sont pressés sur le bord dans la couche de matière plastique.

22. Procédé selon l'une des revendications 1 à 21 pour le traitement thermique de plaques de verre feuilleté qui présentent au moins une plaque de verre en verre de silicate de sodium calcique ou en verre au borosilicate.

23. Procédé selon l'une des revendications 1 à 21 pour le traitement thermique de plaques de verre feuilleté avec au moins une couche en matière plastique constituée sensiblement par des polyuréthannes aliphatiques ou aromatiques, du polyvinylbutyral, de l'éthylène-acétate de vinyle, des dérivés d'acide acrylique tels que n-butyle acrylate, des époxydes, des silicones ou des mélanges de ceux-ci.

24. Procédé selon l'une des revendications 1 à 21 pour le traitement thermique de plaques de verre feuilleté, dans lequel des cellules solaires agencées sur et/ou dans la couche de matière plastique sont en silicium, en bi-séléniure d'indium-cuivre, en arséniure de gallium ou en tellurure de cadmium.

25. Procédé selon l'une des revendications 1 à 21 pour le traitement thermique de plaques de verre feuilleté, dans lesquelles au moins une autre plaque de verre est reliée à titre d'autre composant à la couche de matière plastique, en particulier pour le traitement thermique de plaques de verre isolant présentant des écarteurs ou de plaques en verre de sécurité feuilleté.
